# EUROPEAN PATENT APPLICATION

(11) **EP 3 886 138 A1**
(43) Date of publication of application: **29.09.2021**
(21) Application number: 20165312.8
(22) Date of filing: 24.03.2020
(51) Int. Cl.: H01J 37/02, H01J 37/28

(54) **FLOOD COLUMN, CHARGED PARTICLE TOOL AND METHOD FOR CHARGED PARTICLE FLOODING OF A SAMPLE**

(71) Applicant: ASML Netherlands B.V., 5500 AH Veldhoven (NL)
(72) Inventor: VAN SOEST, Jurgen, 5500 AH Veldhoven (NL); BERGLUND, Gun Sara Mari, 5500 AH Veldhoven (NL); HUANG FOEN CHUNG, Robert Wong Joek Meu, 5500 AH Veldhoven (NL); MARTINEZ NEGRETE GASQUE, Diego, 5500 AH Veldhoven (NL); DINU GURTLER, Laura, 5500 AH Veldhoven (NL)
(74) Representative: ASML Netherlands B.V.

(57) **Abstract**

A flood column for charged particle flooding of a sample, the flood column comprising a charged particle source configured to emit a charged particle beam along a beam path; a source lens arranged down-beam of the charged particle source; a condenser lens arranged down-beam of the source lens; and an aperture body arranged down-beam of the condenser lens, wherein the aperture body is for passing a portion of the charged particle beam; and wherein the source lens is controllable so as to variably set the beam angle of the charged particle beam down-beam of the source lens.

## Description

### FIELD

The present invention relates to a flood column, a charged particle tool comprising the flood column, and a method for charged particle flooding of a sample.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Dedicated flood columns may be used in conjunction with an SEM to flood a large area of the surface of a substrate or other sample with charged particles, for example directing a large current such as a high density current to the sample, in a relatively short time.. Flood columns are thus useful tools to pre-charge a wafer surface and set the charging conditions for subsequent inspection with an SEM. A dedicated flood column can enhance the voltage contrast defect signal, thereby increasing the defect detection sensitivity and/or throughput of an SEM. During charged particle flooding, the flood column is used to provide a relatively large amount of charged particles, for example as current, to quickly charge a predefined area. Afterwards, the primary electron source of an e-beam inspection system is applied to scan an area within the pre-charged area to achieve imaging of the area.

### SUMMARY

Embodiments of the invention are directed to a flood column and a charged particle tool comprising the flood column.

According to the present invention, there is provided a flood column for charged particle flooding of a sample, the flood column comprising: a charged particle source configured to emit a charged particle beam along a beam path, a source lens arranged down-beam of the charged particle source; a condenser lens arranged down-beam of the source lens; and an aperture body arranged down-beam of the condenser lens, wherein the aperture body is for passing a portion of the charged particle beam; and wherein the source lens is controllable so as to variably set the beam angle of the charged particle beam down-beam of the source lens.

According to the present invention, there is provided a flood column for charged particle flooding of a sample, the flood column comprising: a charged particle source configured to emit a charged particle beam along a beam path, a source lens arranged down-beam of the charged particle source; a condenser lens arranged down-beam of the source lens; and an aperture body arranged down-beam of the source lens, wherein the aperture body is for passing a portion of the charged particle beam; and a controller configured to selectively operate the flood column in a high-density mode for charged particle flooding of a relatively small area of the sample, and a low-density mode for charged particle flooding of a relatively large area of the sample.

According to the present invention, there is provided a flood column for charged particle flooding of a sample, the flood column comprising: a charged particle source configured to emit a charged particle beam along a beam path, a condenser lens arranged down-beam of the charged particle source; an aperture body arranged down-beam of the condenser lens, wherein the aperture body is for passing a portion of the charged particle beam; and an objective lens arranged down-beam of the aperture body; wherein the objective lens is controllable so as to adjust the focus of the charged particle beam to a cross-over point up-beam of the sample, such that the lateral extent of the charged particle beam at the sample is larger than lateral extent of the charged particle beam at the objective lens.

According to the present invention, there is provided a charged particle tool for projecting a charged particle multi-beam to a sample, the charged particle tool comprising the flood column of a flood columns provided by the invention.

According to the present invention, there is provided a method for charged particle flooding of a sample using a flood column, the method comprising: emitting a charged particle beam along a beam path using a charged particle source; variably setting the beam angle of the emitted charged particle beam using a source lens arranged down-beam of the charged particle source; adjusting the beam angle of the charged particle beam using a condenser lens arranged down-beam of the source lens; and passing a portion of the charged particle beam using an aperture body arranged down-beam of the condenser lens.

According to the present invention, there is provided a method for charged particle flooding of a sample using a flood column, the method comprising: emitting a charged particle beam along a beam path using a charged particle source; adjusting the beam angle of the charged particle beam using a condenser lens arranged down-beam of the charged particle source; passing a portion of the charged particle beam using an aperture body arranged down-beam of the condenser lens; and selectively operating the flood column in a high-density mode for charged particle flooding of a relatively small area of the sample, and a low-density mode for charged particle flooding of a relatively large area of the sample.

According to the present invention, there is provided a method for charged particle flooding of a sample using a flood column, the method comprising: emitting a charged particle beam along a beam path using a charged particle source; adjusting the beam angle of the charged particle beam using a condenser lens arranged down-beam of the charged particle source; passing a portion of the charged particle beam using an aperture body arranged down-beam of the condenser lens; and focusing the charged particle beam to a cross-over point up-beam of the sample using an objective lens, such that the lateral extent of the charged particle beam at the sample is larger than lateral extent of the charged particle beam at the objective lens.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings, in which:
**FIG. 1** schematically depicts a charged particle beam inspection apparatus;
**FIG. 2** schematically depicts a charged particle tool, which may form part of the charged particle beam inspection apparatus of **FIG. 1**;
**FIG. 3a** schematically depicts an embodiment of a flood column, for example in a high-density mode of operation; and
**FIG. 3b** schematically depicts an embodiment of a flood column, for example in a low-density mode of operation.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination system that comprises an electron source, for generating primary electrons, and a projection system for scanning a sample, such as a substrate, with one or more focused beams of primary electrons. The primary electrons interact with the sample and generate secondary electrons. A detection system captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

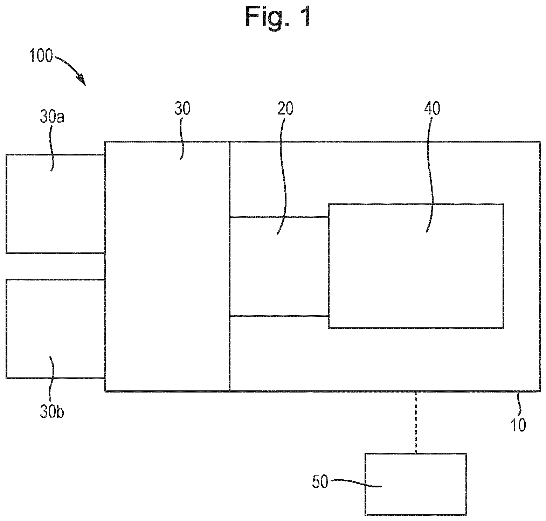

Reference is now made to Fig. 1, which is a schematic diagram illustrating a charged particle beam inspection apparatus 100. The charged particle beam inspection apparatus 100 of Fig. 1 includes a main chamber 10, a load lock chamber 20, a charged particle tool 40, an equipment front end module (EFEM) 30 and a controller 50. Charged particle tool 40 is located within main chamber 10. Charged particle tool 40 may be an electron beam tool 40. Charged particle tool 40 may be a single-beam tool or a multi-beam tool.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be subject to charged particle flooding and/or inspection.

Controller 50 is electronically connected to charged particle beam tool 40. Controller 50 may be a processor (such as a computer) configured to control the charged particle beam inspection apparatus 100. Controller 50 may also include a processing circuitry configured to execute various signal and image processing functions. While controller 50 is shown in Fig. 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements.

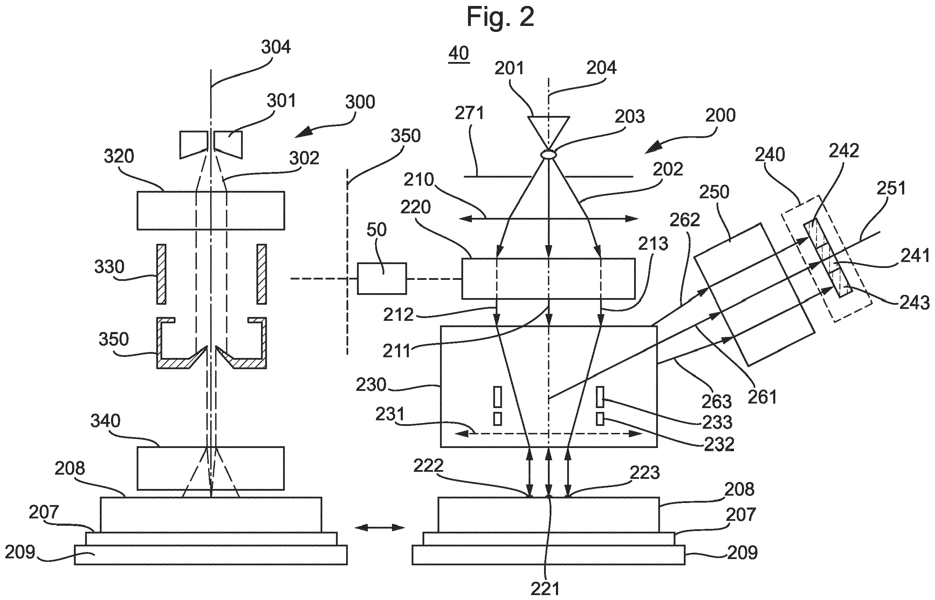

Reference is now made to **FIG. 2**, which is a schematic diagram illustrating an exemplary charged particle tool 40. The charged particle tool 40 may form part of the charged particle beam inspection apparatus 100 of Fig. 1. The charged particle tool 40 may comprise a charged particle inspection tool 200. As shown in Fig. 1, the charged particle inspection tool 200 may be a multi-beam inspection tool 200. Alternatively, the charged particle inspection tool 200 may be a single-beam inspection tool. The charged particle inspection tool 200 comprises an electron source 201, a gun aperture plate 271, a condenser lens 210, optionally a source conversion unit 220, a primary projection system 230, a motorized stage 209, and a sample holder 207. The electron source 201, the gun aperture plate 271, the condenser lens 210, and optionally the source conversion unit 220 are the components of an illumination system comprised by the charged particle inspection tool 200. The sample holder 207 is supported by motorized stage 209 so as to hold and optionally to position a sample 208 (e.g., a substrate or a mask), for example for inspection or for charged particle flooding. The charged particle inspection tool 200 may further comprise a secondary projection system 250 and an associated electron detection device 240 (which together may form a detection column or detection system). Electron detection device 240 may comprise a plurality of detection elements 241, 242, and 243. Primary projection system 230 may comprise an objective lens 231 and optionally the source conversion unit 220 (if it is not part of the illumination system). Together the primary projection system and the illumination system may be referred to as a primary column or primary electron-optical system. A beam separator 233 and a deflection scanning unit 232 may be positioned inside primary projection system 230.

The components that are used to generate a primary beam may be aligned with a primary electron-optical axis of the charged particle inspection tool 200. These components can include: the electron source 201, gun aperture plate 271, condenser lens 210, source conversion unit 220, beam separator 233, deflection scanning unit 232, and primary projection apparatus 230. Secondary projection system 250 and its associated electron detection device 240 may be aligned with a secondary electron-optical axis 251 of the charged particle inspection tool 200.

The primary electron-optical axis 204 is comprised by the electron-optical axis of the part of the charged particle inspection tool 200 that is the illumination system. The secondary electron-optical axis 251 is the electron-optical axis of the part of the charged particle inspection tool 200 that is a detection system (or detection column). The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

In this arrangement a primary electron beam, by the time it reaches the sample, and preferably before it reaches the projection system, is a multi-beam. Such a multi-beam can be generated from the primary electron beam in a number of different ways. For example, the multi-beam may be generated by a multi-beam array located before the cross-over, a multi-beam array located in the source conversion unit 220, or a multi-beam array located at any point in between these locations. A multi-beam array may comprise a plurality of electron beam manipulating elements arranged in an array across the beam path. Each manipulating element may influence the primary electron beam to generate a sub-beam. Thus the multi-beam array interacts with an incident primary beam path to generate a multi-beam path down-beam of the multi-beam array.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also be referred to as a coulomb aperture array.

Condenser lens 210 is configured to focus primary electron beam 202. Condenser lens 210 may be designed to focus primary electron beam 202 to become a parallel beam and be normally incident onto source conversion unit 220. Condenser lens 210 may be a movable condenser lens that may be configured so that the position of its first principle plane is movable. The movable condenser lens may be configured to be magnetic. Condenser lens 210 may be an anti-rotation condenser lens and/or it may be movable.

Source conversion unit 220 may comprise an image-forming element array, an aberration compensator array, a beam-limit aperture array, and a pre-bending micro-deflector array. The pre-bending micro-deflector array may deflect a plurality of primary sub-beams 211, 212, 213 of primary electron beam 202 to normally enter the beam-limit aperture array, the image-forming element array, and an aberration compensator array. In this arrangement, the image-forming element array may function as a multi-beam array to generate the plurality of sub-beams in the multi-beam path, i.e. primary sub-beams 211, 212, 213. The image forming array may comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may comprise a field curvature compensator array (not shown) and an astigmatism compensator array (not shown). The field curvature compensator array may comprise a plurality of micro-lenses to compensate field curvature aberrations of the primary sub-beams 211, 212, and 213. The astigmatism compensator array may comprise a plurality of micro-stigmators, or multi-pole electrodes, to compensate astigmatism aberrations of the primary sub-beams 211, 212, and 213. The beam-limit aperture array may be configured to limit diameters of individual primary sub-beams 211, 212, and 213. **FIG. 2** shows three primary sub-beams 211, 212, and 213 as an example, and it should be understood that source conversion unit 220 may be configured to form any number of primary sub-beams. Controller 50 may be connected to various parts of charged particle beam inspection apparatus 100 of **FIG. 1**, such as source conversion unit 220, electron detection device 240, primary projection system 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams. The electric currents may be changed by both altering the radial sizes of beam-limit apertures and the focusing power of condenser lens 210. If the condenser lens is moveable and magnetic, off-axis sub-beams 212 and 213 may result that illuminate source conversion unit 220 with rotation angles. The rotation angles change with the focusing power or the position of the first principal plane of the movable condenser lens. A condenser lens 210 that is an anti-rotation condenser lens may be configured to keep the rotation angles unchanged while the focusing power of condenser lens 210 is changed. Such a condenser lens 210 that is also movable, may cause the rotation angles not change when the focusing power of the condenser lens 210 and the position of its first principal plane are varied.

Objective lens 231 may be configured to focus sub-beams 211, 212, and 213 onto a sample 208 for inspection and may form three probe spots 221, 222, and 223 on the surface of sample 208.

Beam separator 233 may be, for example, a Wien filter comprising an electrostatic deflector generating an electrostatic dipole field and a magnetic dipole field (not shown in **FIG. 2**). In operation, beam separator 233 may be configured to exert an electrostatic force by electrostatic dipole field on individual electrons of primary sub-beams 211, 212, and 213. The electrostatic force is equal in magnitude but opposite in direction to the magnetic force exerted by magnetic dipole field of beam separator 233 on the individual electrons. Primary sub-beams 211, 212, and 213 may therefore pass at least substantially straight through beam separator 233 with at least substantially zero deflection angles.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. The secondary electrons propagate in three secondary electron beams 261, 262, and 263. The secondary electron beams 261, 262, and 263 typically have secondary electrons (having electron energy ≤ 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection system 250. The secondary projection system 250 subsequently focuses the path of secondary electron beams 261, 262, and 263 onto a plurality of detection regions 241, 242, and 243 of electron detection device 240. The detection regions may be the separate detection elements 241, 242, and 243 that are arranged to detect corresponding secondary electron beams 261, 262, and 263. The detection regions generate corresponding signals which are sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Although **FIG. 2** shows that the charged particle inspection tool 200 uses three primary electron sub-beams, it is appreciated that the charged particle inspection tool 200 may use two or a greater number of primary electron sub-beams. The present disclosure does not limit the number of primary electron beams used in the charged particle inspection tool 200. The charged particle inspection tool 200 may also be a single-beam inspection tool 200, which uses a single charged particle beam.

As shown in Fig. 2, the charged particle beam tool 40 may further comprise a flood column 300 or flood gun. The flood column 300 may be used to pre-charge the surface of the sample 208 and set the charging conditions. For example the flood column may pre-charge the surface of the sample 208 prior to inspection by the charged particle inspection apparatus 200. This may enhance the voltage contrast defect signal, so as to increase the defect detection sensitivity and/or throughput of the charged particle inspection apparatus 200. The flood column 300 may be used to provide a relatively large amount of charged particles to charge a predefined area. Afterwards, the charged particle inspection apparatus 200 may scan the pre-charged area of the sample 208 to achieve imaging of the area. The motorized stage 209 may move the sample 208 from a position for charged particle flooding by the flood column 300 to a position for inspection by the charged particle inspection apparatus 200. Put another way, the motorized stage 209 may be used to move the sample 208 into the position for charged particle flooding, then the flood column 300 may flood the sample 208 with charged particles, then the motorized stage 209 may be used to move the sample 208 into the position for inspection, and then the charged particle inspection apparatus 200 may be used to inspect the sample 208. Alternatively, the position for charged particle flooding by the flood column 300 may coincide with the position for inspection by the charged particle inspection apparatus 200, such that the sample 208 and the motorized stage 209 remain substantially in place after charged particle flooding and before inspection.

The flood column 300 may comprise a charged particle source 301 which may be in a generator system, a condenser lens 320, a blanker electrode 330, an objective lens 340 and an aperture body 350. The flood column 300 may also comprise additional components for manipulation of the charged particle beam 302 such as a scanning element (not shown) and a field lens (not shown). The components of the flood column 300 may be arranged substantially along an axis 304. The axis 304 may be the electro-optical axis of the flood column 300. The components of the flood column 300 may be controlled by the controller 50. Alternatively, a dedicated controller may be used to control the components of the flood column 300, or the components of the flood column 300 may be controlled by multiple respective controllers. The flood column 300 may be mechanically coupled to the charged particle inspection apparatus 200, in particular to the primary column of the charged particle inspection apparatus 200, at an interface 350 between the flood column 300 and the primary column.

The charged particle source 301 may be an electron source. The charged particle source 301 may comprise a charged particle emitting electrode (e.g. a cathode) and an accelerating electrode (e.g. an anode). The charged particles are extracted or accelerated from the charged particle emitting electrode by the accelerating electrode to form a charged particle beam 302. The charged particle beam 302 may propagate along a beam path 302. The beam path 302 may comprise the axis 304, for example in situations in which the charged particle beam 302 is not deflected away from the axis 304.

The condenser lens 320 is positioned down-beam of the charged particle source 301, i.e. the condenser lens 320 is positioned in a down-beam direction relative to the charged particle source 301. The condenser lens 320 may focus or defocus the charged particle beam 302. As shown in Fig. 2, the condenser lens 320 may be used to collimate the charged particle beam 302. However, the condenser lens 320 may also be used to control the charged particle beam 302 so as to create a divergent beam or a convergent beam.

The aperture body 350 may be positioned down-beam of the condenser lens 320. The aperture body 350 may pass a portion, or only a portion and not all, of a charged particle beam propagating along an axis 304. The aperture body 350 may limit the lateral extent of the charged particle beam 302, as depicted in Fig. 2. The aperture body 350 may also be used to selectively blank the charged particle beam 302, so as to prevent passage of any portion of the charged particle beam 302. The aperture body 350 may define an opening. If the lateral extent (or diameter) of the charged particle beam 302 is larger than the lateral extent (or diameter) of the opening, then only a portion of the charged particle beam 302 will pass through the opening. The aperture body 350 may thus limit the lateral extent of the charged particle beam 302, so as to act as a beam-limiting aperture. The cross section of the beam down-beam of the aperture body 350 may be geometrically similar (in case of a divergent or convergent beam) or geometrically identical (in case of a collimated beam) to the cross-section of the opening in the aperture body 350. The opening may be substantially circular. The opening may have a lateral extent (or diameter) in the range from 100µm to 10mm, preferably from 200µm to 5mm, further preferably from 500µm to 2mm

The blanking electrode 330 may be positioned down-beam of the condenser lens 320 and up-beam of the aperture body 350. The blanking electrode 330 may selectively deflect the charged particle beam 302, for example deflect the charged particle beam 302 away from the axis 304. The blanking electrode 330 may deflect the charged particle beam 302 away from the opening in the aperture body 350, for example onto a portion of the aperture body 350 that does not comprise the opening, so as to prevent any portion of the charged particle beam 302 from passing through the opening defined by the aperture body 350. The blanking electrode 330 may blank the beam so that beam does not pass through the opening of the aperture body 350. However, the combination of the blanking electrode 330 and the aperture body 350 may also be used to selectively blank the charged particle beam 302, i.e. to selectively prevent passage of at least part the charged particle beam 302 through the opening in the aperture body 350. That is, the combination of the blanking electrode 330 and the aperture body 350 may selectively control the proportion of the charged particle beam 302 that passes the opening.

The objective lens 340 is positioned down-beam of the aperture body 350. The objective lens 340 may focus or defocus the charged particle beam 302. As shown in Fig. 2, the objective lens 320 may be used to control the charged particle beam 302 so as to create a divergent beam, thereby increasing the spot size on the sample 208 and increasing the area of the surface on the sample 208 that is flooded with charged particles. However, in some situations, the objective lens 340 may be used to control the charged particle 302 so as to create a convergent beam, thereby focusing the charged particle beam 302 onto the sample 208. A field lens (not shown in Fig. 2), for example positioned down-beam of the objective lens, may be used to set the strength of the electric field between the field lens and the sample 208. This electric field affects the charged particle as they travel towards the sample 208, thereby affecting the charging speed and the charging level (i.e. the maximum voltage of the sample 208 with respect to electrical ground after charged particle flooding) of the sample 208 during charged particle flooding.

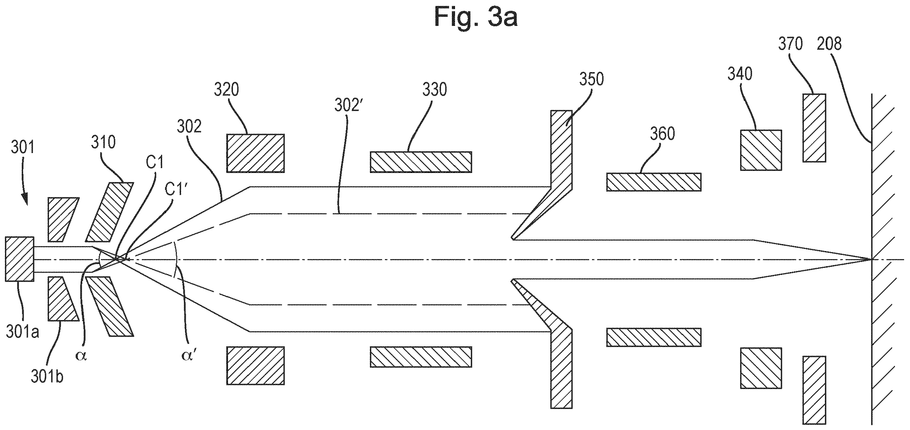

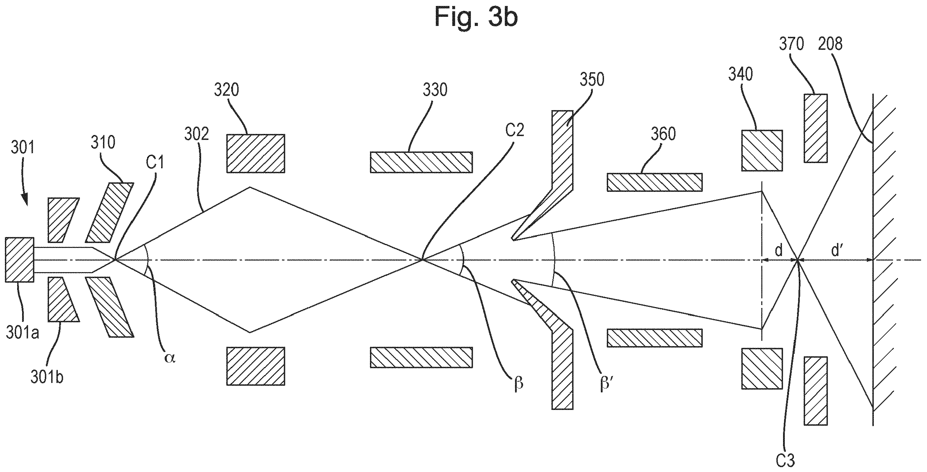

Figs. 3a and 3b schematically depict an embodiment of the flood column 300, such as the flood column 300 in Fig. 2. The flood column 300 may comprise the charged particle source 301, the condenser lens 320, the blanking electrode 330, the aperture body 350, the objective lens 340, and the field lens 370. The charged particle source 301 comprises the charged particle emitting electrode 301a (e.g. the cathode) and the accelerating electrode 301b (e.g. the anode). The flood column may additionally comprise a source lens 310. Optionally, the flood column 300 may comprise scanning electrodes 360.

The flood column 300 may selectively be operated in different modes of operation, such as in a high-density mode (as schematically depicted in Fig. 3a) and in a low-density mode (as schematically depicted in Fig. 3b). The flood column 300 may switch between the high-density mode and the low-density mode of operation. Alternatively, the flood column 300 may be operated in only one mode of operation, such as in either one of the high-density mode and the low-density mode. The controller 50 may control the mode of operation of the flood column 300, so as to selectively operate the flood column 300 in the high-density mode and in the low-density mode. A user may instruct the flood column 300, or the controller 50, to selectively operate in one of the modes of operation. Alternatively, the controller 50 may automatically control the mode of operation of the flood column 300, for example based on a pre-set program or order of operations.

The high-density mode is for charged particle flooding of a relatively small area of the sample 208. In the high-density mode, the lateral extent (or diameter) of the charged particle beam 302 incident at the sample 208, also referred to as the lateral extent (or diameter) of the beam spot herein, is relatively small. The lateral extent (or diameter) of the beam spot in the high-density mode is relatively small, in particular compared to the lateral extent (or diameter) of the beam spot in the low-density mode. As such, the charge density of the beam spot in the high-density mode is relatively high, in particular compared to the charge density of the beam spot in the low-density mode. In the high-density mode, the lateral extent (or diameter) of the beam spot may be in the range from 0 to 1000µm, preferably between 5µm and 500µm. However, the spot size is dependent on the application. The typical application requirements are in the range of 25µm to 500µm, which is the preferred operational range of an embodiment. The beam spot can then be selected from the operation range during operation dependent on the application. An upper limit of the operation range is selected because above 500µm the required current density is difficult to achieve. With available optics a lower limit to the range can be higher than 5µm, for example 10µm, 25µm or 50µm.

The low-density mode is for charged particle flooding of a relatively large area of the sample 208. In the low-density mode, the lateral extent (or diameter) of the beam spot is relatively large, in particular compared to the lateral extent (or diameter) of the beam spot in the high-density mode. As such, the charge density of the beam spot in the low-density mode is relatively low, in particular compared to the charge density of the beam spot in the high-density mode. In the low-density mode, the lateral extent (or diameter) of the beam spot may be greater than 500µm, preferably greater than 1mm, further preferably greater than 3mm, particularly preferably greater than 5mm, for example about 8mm. The lateral extent (or diameter) of the beam spot in the low-density mode may be in the range from 500µm to 50mm, preferably from 1mm to 20mm, further preferably from 3mm to 15mm, particularly preferably from 5mm to 12mm.

As shown in Figs. 3a and 3b, the flood column 300 may comprise the source lens 310. The source lens 310 is arranged or located down-beam, for example directly down-beam, of the charged particle source 301, in particular down-beam of the accelerating electrode (e.g. the anode) of the charged particle source 301. The source lens 310 is arranged or located up-beam of the condenser lens 320, for example directly up-beam of the condenser lens 320. The source lens 310 may manipulate the charged particle beam 302, in particular by adjusting the focus or the beam angle α of the charged particle beam 302 down-beam of the source lens 310 and up-beam of the condenser lens 320. (Note that all references to beam angles in this specification are the maximum angular displacement across the beam cross-section. An alternative definition of beam angle could be the maximum angular displacement of the beam relative to the electron-optical axis, shown in dotted lines in Figs 3a and 3b. The alternative definition of beam angle, relative to the axis, would be half of that beam angle provided herein). The source lens 310 preferably manipulates the charged particle beam 302 so as to create a divergent charged particle beam 302 up-beam of the condenser lens 320. As shown in Figs. 3a and 3b, the source lens 310 may focus the charged particle beam to a cross-over point C1 that is located up-beam of the condenser lens 320, thereby creating a divergent charged particle beam 302 up-beam of the condenser lens 320 (and down-beam of the cross-over point C1). In some arrangements, this may allow a larger beam divergence (i.e. a larger beam angle a) compared to defocusing the charged particle beam 320. Alternatively, the source lens 310 may defocus the charged particle beam 302, thereby creating a divergent charged particle beam 302 up-beam of the condenser lens 320 (not shown). By defocusing, the source lens diverges the beam path relative to a virtual cross-over point up-beam of the source lens 310. The beam angle α of the diverging beam is thus determined relative to the virtual cross-over point Reference in the following text to the beam angle α should be understood to refer to both embodiments with a cross-over and a virtual cross-over up-beam of the source lens 310.

As shown in Fig. 3a, for example in the high-density mode, the source lens 310 may be controllable so as to variably set the beam angle α (or the amount of focus/defocus) of the charged particle beam 302, thus the extent of divergence of the charged particle beam 302, down-beam of the source lens 310 (for a virtual cross-over) or down-beam of the cross-over point C1. When the source lens 310 focusses the charged particle beam 302 onto the cross-over point C1, the source lens 310 may be controllable so as to variably set the position of the cross-over point C1 along the axis 304. The source lens 310 may thus be used to vary the beam angle α of the charged particle beam 302. The source lens 310 may be used to set the beam angle α to a plurality of (predetermined) values within a range. Alternatively, the source lens 310 may be used to vary the beam angle α within a predetermined continuous range. The source lens 310 may, for example, vary the beam angle α within the range at least from 0° to 5°, preferably at least from 0° to 10°. This may adjust the lateral extent of the charged particle beam 302 (e.g. of the collimated charged particle beam 302, 302' depicted in Fig. 3a) down-beam of the condenser lens 320 and up-beam of the aperture body 350. Adjust the lateral extent of the charged particle beam 302 may variably set the proportion of the charged particle beam 302 that passes through the aperture body 350. The source lens 310 may, for example, vary the proportion of the charged particle beam 302 that passes through the aperture body within a range at least from 100% to 50%, preferably at least from 100% to 25%, further preferably at least from 100% to 10%, particularly preferably at least from 100% to 5%.

For example, Fig. 3a shows that the source lens 310 may selectively set the beam angle to α or α', thereby respectively creating the cross-over points C1 and C1'. As depicted in Fig. 3a, this varies the lateral extent of the charged particle beam 302, 302' up-beam of the aperture body 350, and independently from the beam angle of the charged particle beam 302 up-beam of the aperture body 350 (which beam angle may be set by the condenser lens 320 - for example to zero degrees 0° relative to the electron-optical axis to create a collimated charged particle beam 302). Variably setting the beam angle α, α' using the source lens 310 thus effectively variably sets the proportion of the charged particle beam 302, 302' that passes through the aperture body 350. With reference to Fig. 3a, when the source lens 310 sets a relatively large beam angle α, the lateral extent of the charged particle beam 302 up-beam of the aperture 350 is relatively large, such that a relatively small proportion of the charged particle beam 302 passes the aperture body 350. Conversely, when the source lens 310 sets a relatively small beam angle α', the lateral extent of the charged particle beam 302' up-beam of the aperture 350 is relatively small, such that a relatively large proportion of the charged particle beam 302' passes the aperture body 350.

Alternatively or additionally, for example in the low-density mode, the source lens 310 may also be controllable so as to set, or fixedly set, the beam angle α (or the amount of focus/defocus) of the charged particle beam 302 down-beam of the source lens 310. This is shown, for example, in Figure 3b. When the source lens 310 focusses the charged particle beam 302 to the cross-over point C1, the source lens 310 may be controllable so as to set, or fixedly set, the position of the cross-over point C1 (which may be virtual and up-beam of the source lens 310) along the axis 304. This may fixedly set the proportion of the charged particle beam 302 that passes through the aperture body 350. The source lens 310 may, for example, set the beam angle α to the maximum beam angle used in the high-density mode. The source lens 310 may set the beam angle α so as to maximize the lateral extent of the charged particle beam at the condenser lens 320. This may create a maximally divergent beam down-beam of the aperture body 350, which ultimately may achieve the maximum spot size at the sample 208. For example, the source lens 310 may achieve a magnification of the charged particle beam 302 (from the source lens 310 to the condenser lens 320) in the range from 1 to 20, preferably from 2 to 15, further preferably from 5 to 10.

As shown in Fig. 3a, for example for the high density mode, the condenser lens 320 may be controllable so as to collimate, or substantially collimate, the charged particle beam 302. The condenser lens 320 may be controllable to set the beam angle of the charged particle beam 302 down-beam of the condenser lens 320 and up-beam of the aperture body 350 to 0°, or substantially 0°, for example to a value in the range from 0° to 5° relative to the direction of the axis 304. The condenser lens 320 may be controllable so as to fixedly set the beam angle of the charged particle beam 302 up-beam of the aperture body 350. The condenser lens 320 may thus counteract any effects that the source lens 310 may have on the beam angle of the charged particle beam 302 (just) up-beam of the aperture body 350.

Alternatively or additionally, as shown in Fig. 3b, for example in the low-density mode, the condenser lens 350 may be controllable so as to create a divergent charged particle beam 302 up-beam of the aperture body 305. The condenser lens 320 may be controllable, for example, so as to focus the charged particle beam 302 to a cross-over point C2 down-beam of the condenser lens 320 and up-beam of the aperture body 350, such that the charged particle beam 302 diverges up-beam of the aperture body and down-beam of the aperture body. This may increase the lateral extent of the charged particle beam 302 at the objective lens 340, compared to a situation in which the charged particle beam 302 down-beam of the aperture body 350 is collimated. See for example a comparison of Figs. 3b and 3a. The increased lateral extent of the charged particle beam 302 at the objective lens 340 allows the objective lens to further increase or maximise the beam spot at the sample 208. The objective lens 340 may focus the charged particle beam 302. The focussing effect of the objective lens 340 on charged particles in the charged particle beam is greater on charged particles that are displaced further from the axis 304 (and thereby closer to the electrodes of the objective lens 340) than those charged particle in the charged particle beam 302 that are closer to the axis 304. Thus, the focussing effect of the objective lens 340 achieves a greater displacement of charged particles further from the axis 304. The condenser lens 320 may set the beam angle β or the position of the cross-over point C2 such that a proportion of the charged particle beam 302 passes through the aperture body 350, for example less 60%, preferably less than 50%, further optionally less than 40% of the charged particle beam 302. For some applications a proportion passing the aperture could be as low as 20% or even 10%. The distribution of charged particles in the charged particle beam 302 up-beam of the aperture body 350 may be less uniform at the edges of the charged particle beam 302 than at the centre of the charged particle beam 302. The distribution of charged particles in the charged particle beam 302 up-beam of the aperture body 350 may be a Gaussian distribution, for example. Passing such a charged particle beam 302 through the aperture body 350 may limit the lateral extent of the charged particle beam 302 so as to remove the edges of the charged particle beam 302. As such, only the centre of the charged particle beam 302 may pass through the aperture body 350. This may lead to an improvement in the uniformity of the charged particle beam 302 down-beam of the aperture body 350 compared to the charged particle beam 302 up-beam of the aperture body 350. Passing only a smaller proportion of the charged particle beam 302 through the aperture body 350 may also limit the current reaching the sample 208, which may be beneficial in some applications.

The aperture body 350 is preferably arranged down-beam of the condenser lens 320. In some embodiments, the aperture body 350 may be arranged up-beam of the condenser lens and down-beam of the source lens 310. Having the aperture body 350 down beam of the condenser lens may be preferred because in that arrangement greater control of the beam and its beam spot may be achieved. The aperture body 350 is for passing at least a portion of the charged particle beam 302. The aperture body 350 may limit the lateral extent of the charged particle beam 302, for example in both the high-density mode of Fig. 3a and in the low-density mode of Fig. 3b. In some situations, the aperture body 350 may not limit the lateral extent of the charged particle beam 302, and all of the charged particle beam 302 may pass through the aperture body 302. When the charged particle beam 302 is divergent up-beam of the aperture body 350, the aperture body 350 may affect the beam angle of the charged particle beam 302, in that the beam angle β up-beam of the aperture body 350 is larger than the beam angle β' down-beam of the aperture body 350, as apparent from Fig. 3b.

Optionally, the blanking electrode 330 is arranged up-beam of the aperture body 350. The blanking electrode 330 may be arranged down-beam of the condenser lens 330. The blanking electrode 300 may deflect the charged particle beam 302 away from the axis 304 so as to prevent any portion of the charged particle beam 302 from passing the aperture body 350, for example towards sample 208.

The objective lens 340 is arranged down-beam of the aperture body 350. The objective lens 340 is controllable so as to adjust the focus of the charged particle beam 302. Using the objective lens 340 to adjust the focus of the charged particle beam 302 adjusts the lateral extent (or diameter) of the beam spot formed by the incidence of the charged particle beam 302 on the sample 208.

As shown in Fig. 3a, for example in the high-density mode, the objective lens 340 may be controllable so as to adjust the focus of the charged particle beam 302 such that the lateral extent (or diameter) of the beam spot is smaller than the lateral extent (or diameter) of the charged particle beam 302 at the objective lens 340.

Alternatively or additionally, for example in the low-density mode, the objective lens 340 may be controllable to manipulate the charged particle beam 302 such that the lateral extent (or diameter) of the beam spot is larger than the lateral extent (or diameter) of the charged particle beam 302 at the objective lens 340. This is shown, for example, in Fig. 3b. The objective lens 340 may be controllable so as to adjust the focus of the charged particle beam 302 to a cross-over point C3 up-beam of the sample 208, such that the lateral extent (or diameter) of the beam spot is larger than the lateral extent (or diameter) of the charged particle beam 302 at the objective lens 340. Preferably, the cross-over point C3 is located up-beam of a final element of the flood column 300, for example up-beam of the field lens 370 of the flood column 300. Creating the cross-over point C3 allows the lateral extent of the beam spot at the sample 208 to be increased compared to a situation in which no cross-over point C3 is created. This may be achieved because the cross-over point C3 may be positioned closer to the final element of the flood column 300 than the (virtual) focus point of a charged particle beam 208 that diverges directly down-beam of the objective lens 340. Thus a beam spot of more than 1mm and for example up to 20mm and even 50mm may be achieved.

The cross-over point C3 may be located such that the ratio d'/d of i) the distance d', along the axis 304, between the cross-over point C3 and the surface of the sample 208 and ii) the distance d, along the axis 304, between the centre of the objective lens 340 and the cross over-point C3, is greater than 1, preferably greater than 1.2, further preferably greater than 1.5, particularly preferably greater than 2. The ratio d'/d may be in the range from 1 to 10, preferably from 1.2 to 6, further preferably from 1.5 to 4, particularly preferably from 2 to 3. In other words, the magnification of the charged particle beam 302 by the objective lens 340 (from the objective lens 340 to the surface of the sample 208) may be in the range from 1 to 10, preferably from 1.2 to 6, further preferably from 1.5 to 4, particularly preferably from 2 to 3

Optionally, the flood column 300 may comprise the scanning electrodes 360, for example a pair of scanning electrodes 360. The scanning electrodes 360 may be arranged or positioned down-beam of the aperture body 350. The scanning electrodes 360 may be arranged or positioned up-beam of the objective lens 340, as shown in Figs. 3a and 3b. Alternatively, the scanning electrodes 360 may be arranged down-beam of the objective lens 340, for example between the objective lens 340 and the field lens 370, or down-beam of the field lens 370.

The scanning electrodes 360, preferably a pair of scanning electrodes 360, may be controllable so as to scan the charged particle beam 302 across the sample 208, for example in the high-density mode. The scanning electrodes 360 may be controllable to variably deflect the charged particle beam 302, for example in one dimension (from top to bottom in Fig. 3a). Optionally, further scanning electrodes may be provided to variably deflect the charged particle beam 302 angularly displaced around the axis 304, so as to scan the charged particle beam 302 across the sample 208. For example, each pair may scan the charged particle beam 302 along a different direction over the sample surface, preferably so that the charged particle beam 302is scanned in two orthogonal dimensions. Deflecting the charged particle beam 302 using the scanning electrodes to scan the sample 208 may be faster than moving the sample 208 relative to a stationary (i.e. non-scanned) charged particle beam 302. The faster speed achieved by scanning may be due to the smaller inertia of the charged particles compared to the motorized stage 209 and sample 208. Especially in situations in which the beam spot on the sample 208 is relatively small (such as in the high-density mode of Fig. 3a), it may thus be helpful to use the scanning electrodes 360 to achieve faster charged particle flooding of the sample 208 (or at least the portion of the sample 208 required to be flooded).

Alternatively or additionally, for example in the low-density mode, the scanning electrodes 360 may be controllable so as not to manipulate the charged particle beam 302. The scanning electrodes 360 may be controllable so as to retain or preserve the beam path of the charged particle beam 302, so as not to deflect the charged particle beam 302. The scanning electrodes 360 may be controllable in this manner, for example, in the low-density mode of operation of the flood column 300. In situations in which the beam spot on the sample 208 is relatively large (such as in the low-density mode of Fig. 3b), the use of the scanning electrodes 360 may reduce the maximum possible extent of the beam spot on the sample 208. This is because deflecting the charged particle beam 302 may require clearance between the charged particle beam 208 and the final element of the flood column. The use of the scanning electrodes 360 may thus be counterproductive to maximizing the lateral extent of the beam spot on the sample 208, for example in the low-density mode of Fig. 3b.

In an embodiment, there is provided the flood column 300 for charged particle flooding of the sample 208. The flood column 300 comprises a charged particle source 301 configured to emit a charged particle beam 302 along a beam path. The flood column 300 further comprises the source lens 301 arranged down-beam of the charged particle source 301. The flood column 300 further comprises the condenser lens 320 arranged down-beam of the source lens 301. The flood column 300 further comprises the aperture body 330 arranged down-beam of the source lens 310, preferably down-beam of the condenser lens 320. The aperture body 350 is for passing a portion of the charged particle beam 302. The flood column 300 further comprises the controller 50. The controller 50 selectively operates the flood column 300 in a high-density mode for charged particle flooding of a relatively small area of the sample 208, and a low-density mode for charged particle flooding of a relatively large area of the sample 208. The source lens 301 may be controllable so as to focus the charged particle beam 302 to the cross-over point C1 up-beam of the condenser lens 320 and to variably set the position of the cross-over point C1 along the a beam path.

In an embodiment, there is provided a method for charged particle flooding of the sample 208 using the flood column 300. The method comprises emitting the charged particle beam 302 along the beam path using the charged particle source 301. The method further comprises variably setting the beam angle α of the emitted charged particle beam 302 using the source lens 310 arranged down-beam of the charged particle source 301. The method further comprises adjusting the beam angle of the charged particle beam 302 using the condenser lens 320 arranged down-beam of the source lens 310. The method further comprises passing a portion of the charged particle beam 302 using the aperture body 350 arranged down-beam of the condenser lens 320.

In an embodiment, there is also provided a method for charged particle flooding of the sample 208 using the flood column 300. The method comprises emitting the charged particle beam 302 along the beam path using the charged particle source 301. The method further comprises adjusting the beam angle α of the charged particle beam 302 using the condenser lens 320 arranged down-beam of the charged particle source 301. The method further comprises passing a portion of the charged particle beam 302 using the aperture body 350 arranged down-beam of the condenser lens 310. The method further comprises selectively operating the flood column 300 in a high-density mode for charged particle flooding of a relatively small area of the sample 208, and a low-density mode for charged particle flooding of a relatively large area of the sample 208.

In an embodiment, there is also provided a method for charged particle flooding of the sample 208 using the flood column 300. The method comprises emitting the charged particle beam 302 along the beam path using the charged particle source 301. The method further comprises adjusting the beam angle α of the charged particle beam 302 using the condenser lens 320 arranged down-beam of the charged particle source 301. The method further comprises passing a portion of the charged particle beam 302 using the aperture body 350 arranged down-beam of the condenser lens 320. The method further comprises focusing the charged particle beam 302 to a cross-over point C3 up-beam of the sample 208 using the objective lens 340, such that the lateral extent of the charged particle beam 302 at the sample 208 is larger than lateral extent of the charged particle beam 302 at the objective lens 240.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims. Reference to inspection throughout this specification is intended also to refer to measurement, i.e. metrological applications. Reference of the charged particle beam 302 up-beam or down-beam of an element includes directly up-beam or directly down-beam of that element. Reference to a first element being up-beam and down-beam of a second element may mean directly up-beam or directly down-beam, but may also, where appropriate, include embodiments in which other elements are provided between the first element and the second element. Reference to a component being controllable to manipulate the charged particle beam 302 in a certain manner includes the controller 50 controlling the component so as to manipulate the component in this manner, as well as other controllers or devices (e.g. voltage supplies) controlling the component so as to so as to manipulate the component in this manner.

Reference to a cross-over point includes a real cross-over point that is achieved by focusing the charged particle beam 302 to the cross-over point (such as the cross-over points C1, C2 and C3 in Fig. 3a and 3b). Where appropriate, reference to a cross-over point may also include a virtual cross-over point that is located up-beam of an element that diverges the charged particle beam 302. The virtual cross-over point is the point from which the charged particle beam 302 appears to diverge.

All references to beam angles in this specification are the maximum angular displacement across the beam cross-section. An alternative definition of beam angle could be the maximum angular displacement of the beam relative to the electron-optical axis, shown in dotted lines in Figs 3a and 3b. The alternative definition of beam angle, relative to the axis, would be half of that beam angle provided herein.

Embodiments are provided the following clauses:
Clause 1: A flood column for charged particle flooding of a sample, the flood column comprising: a charged particle source configured to emit a charged particle beam along a beam path: a source lens arranged down-beam of the charged particle source; a condenser lens arranged down-beam of the source lens; and an aperture body arranged down-beam of the condenser lens, wherein the aperture body is for passing a portion of the charged particle beam; and wherein the source lens is controllable so as to variably set the beam angle of the charged particle beam down-beam of the source lens.
Clause 2:The flood column of clause 1, wherein the condenser lens is controllable so as to collimate the charged particle beam, and wherein the source lens is controllable so as to variably set the beam angle of the charged particle beam down-beam of the source lens, thereby adjusting the lateral extent of the collimated charged particle beam down-beam of the condenser lens and up-beam of the aperture body.
Clause 3: The flood column of clause 1 or 2, wherein the condenser lens is controllable so as to focus the charged particle beam to a cross-over point down-beam of the condenser lens and up-beam of the aperture body, such that the charged particle beam diverges down-beam of the aperture body.
Clause 4: The flood column of any one of clauses 1 to 3, further comprising an objective lens arranged down-beam of the aperture body, wherein preferably the objective lens is controllable so as to adjust the focus of the charged particle beam, thereby adjusting a lateral extent of a beam spot formed by the incidence of the charged particle beam on the sample.
Clause 5: The flood column of clause 4, wherein the objective lens is controllable so as to adjust the focus of the charged particle beam such that the lateral extent of the beam spot is smaller than the lateral extent of the charged particle beam at the objective lens.
Clause 6: The flood column of clause 4 or 5, wherein the objective lens is controllable to manipulate the charged particle beam such that the lateral extent of the beam spot is larger than the lateral extent of the charged particle beam at the objective lens.
Clause 7: The flood column of any one of clauses 4 to 6, wherein the objective lens is controllable so as to adjust the focus of the charged particle beam to a cross-over point up-beam of the sample, such that the lateral extent of the beam spot is larger than the lateral extent of the charged particle beam at the objective lens.
Clause 8: The flood column of any preceding clause, further comprising a pair of scanning electrodes arranged down-beam of the aperture body.
Clause 9: The flood column of clause 8, wherein the pair of scanning electrodes is controllable so as to scan the charged particle beam across the sample.
Clause 10: The flood column of claim 8 or 9, wherein the pair of scanning electrodes is controllable so as not to manipulate the charged particle beam.
Clause 11: The flood column of any preceding clause, further comprising a controller configured to selectively operate the flood column in a high-density mode for charged particle flooding of a relatively small area of the sample and a low-density mode for charged particle flooding of a relatively large area of the sample.
Clause 12: The flood column of clause 11, wherein, in the high-density mode: the source lens is controllable so as to variably set the beam angle of the charged particle beam down-beam of the source lens, and/or the condenser lens is controllable so as to collimate the charged particle beam, and the source lens is controllable so as to variably set the beam angle of the charged particle beam down-beam of the source lens, thereby adjusting the lateral extent of the collimated charged particle beam down-beam of the condenser lens and up-beam of the aperture body; and/or the objective lens is controllable so as to adjust the focus of the charged particle beam such that the lateral extent of the beam spot is smaller than the lateral extent of the charged particle beam at the objective lens; and/or the pair of scanning electrodes is controllable so as to scan the charged particle beam across the sample.
Clause 13: The flood column of clause 11 or 12, wherein, in the low-density mode: the source lens is controllable so as to set the beam angle of the charged particle beam down-beam of the source lens; and/or the condenser lens is controllable so as to focus the charged particle beam to a cross-over point down-beam of the condenser lens and up-beam of the aperture body, such that the charged particle beam diverges down-beam of the aperture body; and/or the objective lens is controllable to manipulate the charged particle beam such that the lateral extent of the beam spot is larger than the lateral extent of the charged particle beam at the objective lens; and/or the pair of scanning electrodes is controllable so as not to manipulate the charged particle beam; and/or the source lens is controllable such that the charged particle beam diverges up-beam of the condenser lens.
Clause 14: A flood column for charged particle flooding of a sample, the flood column comprising: a charged particle source configured to emit a charged particle beam along a beam path; a source lens arranged down-beam of the charged particle source; a condenser lens arranged down-beam of the source lens; and an aperture body arranged down-beam of the source lens, wherein the aperture body is for passing a portion of the charged particle beam; and a controller configured to selectively operate the flood column in a high-density mode for charged particle flooding of a relatively small area of the sample, and a low-density mode for charged particle flooding of a relatively large area of the sample.
Clause 15:The flood column of clause 14, wherein, in the high-density mode: the source lens is controllable so as to variably set the beam angle of the charged particle beam down-beam of the source lens, and/or the condenser lens is controllable so as to collimate the charged particle beam, and the source lens is controllable so as to variably set the beam angle of the charged particle beam down-beam of the source lens, thereby adjusting the lateral extent of the collimated charged particle beam down-beam of the condenser lens and up-beam of the aperture body; and/or the objective lens is controllable so as to adjust the focus of the charged particle beam such that the lateral extent of the beam spot is smaller than the lateral extent of the charged particle beam at the objective lens; and/or the pair of scanning electrodes is controllable so as to scan the charged particle beam across the sample.
Clause 16: The flood column of clause 14 or 15, wherein, in the low-density mode: the source lens is controllable so as to set the beam angle of the charged particle beam down-beam of the source lens; and/or the condenser lens is controllable so as to focus the charged particle beam to a cross-over point down-beam of the condenser lens and up-beam of the aperture body, such that the charged particle beam diverges down-beam of the aperture body; and/or the objective lens is controllable to manipulate the charged particle beam such that the lateral extent of the beam spot is larger than the lateral extent of the charged particle beam at the objective lens; and/or the pair of scanning electrodes is controllable so as not to manipulate the charged particle beam; and/or the source lens is controllable such that the charged particle beam diverges up-beam of the condenser lens.
Clause 17: A flood column for charged particle flooding of a sample, the flood column comprising: a charged particle source configured to emit a charged particle beam along a beam path; a condenser lens arranged down-beam of the charged particle source; and an aperture body arranged down-beam of the condenser lens, wherein the aperture body is for passing a portion of the charged particle beam; an objective lens arranged down-beam of the aperture body; and wherein the objective lens is controllable so as to adjust the focus of the charged particle beam to a cross-over point up-beam of the sample, such that the lateral extent of the charged particle beam at the sample is larger than lateral extent of the charged particle beam at the objective lens.
Clause 18: The flood column of clause 17, further comprising a source lens arranged down-beam of the charged particle source and up-beam of the condenser lens, wherein the source lens is controllable so as to variably set the beam angle of the charged particle beam down-beam of the source lens.
Clause 19: The flood column of clause 17 or 18, wherein the condenser lens is controllable so as to collimate the charged particle beam, and wherein the source lens is controllable so as to variably set the beam angle of the charged particle beam down-beam of the source lens, thereby adjusting the lateral extent of the collimated charged particle beam down-beam of the condenser lens and up-beam of the aperture body.
Clause 20: The flood column of any one of clauses 17 to 19, wherein the condenser lens is controllable so as to focus the charged particle beam to a cross-over point down-beam of the condenser lens and up-beam of the aperture body, such that the charged particle beam diverges down-beam of the aperture body.
Clause 21: The flood column of any one of clauses 17 to 20, wherein the objective lens is controllable so as to adjust the focus of the charged particle beam such that the lateral extent of the beam spot is smaller than the lateral extent of the charged particle beam at the objective lens.
Clause 22: The flood column of any one of clauses 17 to 21, further comprising a pair of scanning electrodes arranged down-beam of the aperture body.
Clause 23: The flood column of clause 22, wherein the pair of scanning electrodes is controllable so as to scan the charged particle beam across the sample.
Clause 24: The flood column of clause 22 or 23, wherein the pair of scanning electrodes is controllable so as not to manipulate the charged particle beam.
Clause 25: The flood column of any one of clauses 17 to 24, further comprising a controller configured to selectively operate the flood column in a high-density mode for charged particle flooding of a relatively small area of the sample and a low-density mode for charged particle flooding of a relatively large area of the sample.
Clause 26: The flood column of clause 25, wherein, in the high-density mode: the source lens is controllable so as to variably set the beam angle of the charged particle beam down-beam of the source lens, and/or the condenser lens is controllable so as to collimate the charged particle beam, and the source lens is controllable so as to variably set the beam angle of the charged particle beam down-beam of the source lens, thereby adjusting the lateral extent of the collimated charged particle beam down-beam of the condenser lens and up-beam of the aperture body; and/or the objective lens is controllable so as to adjust the focus of the charged particle beam such that the lateral extent of the beam spot is smaller than the lateral extent of the charged particle beam at the objective lens; and/or the pair of scanning electrodes is controllable so as to scan the charged particle beam across the sample.
Clause 27:The flood column of clause 25 or 26, wherein, in the low-density mode: the source lens is controllable so as to set the beam angle of the charged particle beam down-beam of the source lens; and/or the condenser lens is controllable so as to focus the charged particle beam to a cross-over point down-beam of the condenser lens and up-beam of the aperture body, such that the charged particle beam diverges down-beam of the aperture body; and/or the objective lens is controllable to manipulate the charged particle beam such that the lateral extent of the beam spot is larger than the lateral extent of the charged particle beam at the objective lens; and/or the pair of scanning electrodes is controllable so as not to manipulate the charged particle beam; and/or the source lens is controllable such that the charged particle beam diverges up-beam of the condenser lens.
Clause 28: A charged particle tool for projecting a charged particle multi-beam to a sample, the charged particle tool comprising the flood column of any proceeding clause.
Clause 29: A method for charged particle flooding of a sample using a flood column, the method comprising: emitting a charged particle beam along a beam path using a charged particle source; variably setting the beam angle of the emitted charged particle beam using a source lens arranged down-beam of the charged particle source; adjusting the beam angle of the charged particle beam using a condenser lens arranged down-beam of the source lens; and passing a portion of the charged particle beam using an aperture body arranged down-beam of the condenser lens.
Clause 30: The method of clause 29, wherein adjusting the beam angle of the charged particle beam using the condenser lens comprises collimating the charged particle beam; and wherein variably setting the beam angle of the charged particle beam down-beam of the source lens, adjusts the lateral extent of the collimated charged particle beam down-beam of the condenser lens and up-beam of the aperture body.
Clause 31: The method of clause 29or 30, further comprising focussing the charged particle beam to a cross-over point down-beam of the condenser lens and up-beam of the aperture body, such that the charged particle beam diverges down-beam of the aperture body.
Clause 32: The method of any one of clauses 29 to 31, further comprising adjusting the focus of the charged particle beam using an objective lens arranged down-beam of the aperture body, thereby adjusting a lateral extent of a beam spot formed by the incidence of the charged particle beam on the sample.
Clause 33: The method of clause 32, wherein adjusting the focus of the charged particle beam using the objective lens comprises adjusting the focus of the charged particle beam such that the lateral extent of the beam spot is smaller than the lateral extent of the charged particle beam at the objective lens.
Clause 34: The method of clause 32 or 33, wherein adjusting the focus of the charged particle beam using the objective lens comprises manipulating the charged particle beam such that the lateral extent of the beam spot is larger than the lateral extent of the charged particle beam at the objective lens.
Clause 35: The method of any one of clauses 32 to 34, wherein adjusting the focus of the charged particle beam using the objective lens comprises focusing the charged particle beam to a cross-over point up-beam of the sample, such that the lateral extent of the beam spot is larger than the lateral extent of the charged particle beam at the objective lens.
Clause 36:The method of any one of clauses 29 to 35, further comprising scanning the charged particle beam across the sample using a pair of scanning electrodes arranged down-beam of the aperture body.
Clause 37: The method of any one of clauses 29 to 36, further comprising selectively operating the flood column in a high-density mode for charged particle flooding of a relatively small area of the sample and a low-density mode for charged particle flooding of a relatively large area of the sample.
Clause 38: The method of clause 37, wherein operating the flood column in the high-density mode comprises: variably setting the beam angle of the emitted charged particle beam using the source lens, and/or collimating the charged particle beam using the condenser lens, and variably setting the beam angle of the emitted charged particle beam using the source lens, thereby adjusting the lateral extent of the collimated charged particle beam down-beam of the condenser lens and up-beam of the aperture body; and/or adjusting the focus of the charged particle beam using the objective lens such that the lateral extent of the beam spot is smaller than the lateral extent of the charged particle beam at the objective lens; and/or scanning the charged particle beam across the sample using the scanning electrodes.
Clause 39: The method of clause 37 or 38, wherein operating the flood column in the low-density mode comprises: setting the beam angle of the emitted charged particle beam using the source lens, preferably such that the charged particle beam diverges up-beam of the condenser lens; and/or focussing the charged particle beam to a cross-over point down-beam of the condenser lens and up-beam of the aperture body using the condenser lens, such that the charged particle beam diverges down-beam of the aperture body; and/or manipulating the charged particle beam using the objective lens such that the lateral extent of the beam spot is larger than the lateral extent of the charged particle beam at the objective lens.
Clause 40: A method for charged particle flooding of a sample using a flood column, the method comprising: emitting a charged particle beam along a beam path using a charged particle source; adjusting the beam angle of the charged particle beam using a condenser lens arranged down-beam of the charged particle source; passing a portion of the charged particle beam using an aperture body arranged down-beam of the condenser lens; and selectively operating the flood column in a high-density mode for charged particle flooding of a relatively small area of the sample, and a low-density mode for charged particle flooding of a relatively large area of the sample.
Clause 41: The method of clause 40, wherein operating the flood column in the high-density mode comprises: variably setting the beam angle of the emitted charged particle beam using the source lens, and/or collimating the charged particle beam using the condenser lens, and variably setting the beam angle of the emitted charged particle beam using the source lens, thereby adjusting the lateral extent of the collimated charged particle beam down-beam of the condenser lens and up-beam of the aperture body; and/or adjusting the focus of the charged particle beam using the objective lens such that the lateral extent of the beam spot is smaller than the lateral extent of the charged particle beam at the objective lens; and/or scanning the charged particle beam across the sample using the scanning electrodes.
Clause 42: The method of clause 40 or 41, wherein operating the flood column in the low-density mode comprises: setting the beam angle of the emitted charged particle beam using the source lens, preferably such that the charged particle beam diverges up-beam of the condenser lens; and/or focussing the charged particle beam to a cross-over point down-beam of the condenser lens and up-beam of the aperture body using the condenser lens, such that the charged particle beam diverges down-beam of the aperture body; and/or manipulating the charged particle beam using the objective lens such that the lateral extent of the beam spot is larger than the lateral extent of the charged particle beam at the objective lens.
Clause 43: A method for charged particle flooding of a sample using a flood column, the method comprising: emitting a charged particle beam along a beam path using a charged particle source; adjusting the beam angle of the charged particle beam using a condenser lens arranged down-beam of the charged particle source; passing a portion of the charged particle beam using an aperture body arranged down-beam of the condenser lens; and focussing the charged particle beam to a cross-over point up-beam of the sample using an objective lens, such that the lateral extent of the charged particle beam at the sample is larger than lateral extent of the charged particle beam at the objective lens

The descriptions above are intended to be illustrative, not limiting. Thus, it will be apparent to one skilled in the art that modifications may be made as described without departing from the scope of the claims set out below.

## Claims

1. A flood column for charged particle flooding of a sample, the flood column comprising
a charged particle source configured to emit a charged particle beam along a beam path,
a source lens arranged down-beam of the charged particle source;
a condenser lens arranged down-beam of the source lens; and
an aperture body arranged down-beam of the condenser lens, wherein the aperture body is for passing a portion of the charged particle beam; and
wherein the source lens is controllable so as to variably set the beam angle of the charged particle beam down-beam of the source lens.

2. The flood column of claim 1, wherein the condenser lens is controllable so as to collimate the charged particle beam, and
wherein the source lens is controllable so as to variably set the beam angle of the charged particle beam down-beam of the source lens, thereby adjusting the lateral extent of the collimated charged particle beam down-beam of the condenser lens and up-beam of the aperture body.

3. The flood column of claim 1 or 2, wherein the condenser lens is controllable so as to focus the charged particle beam to a cross-over point down-beam of the condenser lens and up-beam of the aperture body, such that the charged particle beam diverges down-beam of the aperture body.

4. The flood column of any one of claims 1 to 3, further comprising an objective lens arranged down-beam of the aperture body, wherein preferably the objective lens is controllable so as to adjust the focus of the charged particle beam, thereby adjusting a lateral extent of a beam spot formed by the incidence of the charged particle beam on the sample.

5. The flood column of claim 4, wherein the objective lens is controllable so as to adjust the focus of the charged particle beam such that the lateral extent of the beam spot is smaller than the lateral extent of the charged particle beam at the objective lens.

6. The flood column of claim 4 or 5, wherein the objective lens is controllable to manipulate the charged particle beam such that the lateral extent of the beam spot is larger than the lateral extent of the charged particle beam at the objective lens.

7. The flood column of any one of claims 4 to 6, wherein the objective lens is controllable so as to adjust the focus of the charged particle beam to a cross-over point up-beam of the sample, such that the lateral extent of the beam spot is larger than the lateral extent of the charged particle beam at the objective lens.

8. The flood column of any preceding claim, further comprising a pair of scanning electrodes arranged down-beam of the aperture body.

9. The flood column of claim 8, wherein the pair of scanning electrodes is controllable so as to scan the charged particle beam across the sample.

10. The flood column of claim 8 or 9, wherein the pair of scanning electrodes is controllable so as not to manipulate the charged particle beam.

11. The flood column of any preceding claim, further comprising a controller configured to selectively operate the flood column in a high-density mode for charged particle flooding of a relatively small area of the sample and a low-density mode for charged particle flooding of a relatively large area of the sample.

12. The flood column of claim 11, wherein, in the high-density mode:
the source lens is controllable so as to variably set the beam angle of the charged particle beam down-beam of the source lens, and/or
the condenser lens is controllable so as to collimate the charged particle beam, and
the source lens is controllable so as to variably set the beam angle of the charged particle beam down-beam of the source lens, thereby adjusting the lateral extent of the collimated charged particle beam down-beam of the condenser lens and up-beam of the aperture body; and/or
the objective lens is controllable so as to adjust the focus of the charged particle beam such that the lateral extent of the beam spot is smaller than the lateral extent of the charged particle beam at the objective lens; and/or
the pair of scanning electrodes is controllable so as to scan the charged particle beam across the sample.

13. The flood column of claim 11 or 12, wherein, in the low-density mode:
the source lens is controllable so as to set the beam angle of the charged particle beam down-beam of the source lens; and/or
the condenser lens is controllable so as to focus the charged particle beam to a cross-over point down-beam of the condenser lens and up-beam of the aperture body, such that the charged particle beam diverges down-beam of the aperture body; and/or
the objective lens is controllable to manipulate the charged particle beam such that the lateral extent of the beam spot is larger than the lateral extent of the charged particle beam at the objective lens; and/or
the pair of scanning electrodes is controllable so as not to manipulate the charged particle beam; and/or
the source lens is controllable such that the charged particle beam diverges up-beam of the condenser lens.

14. A charged particle tool for projecting a charged particle multi-beam to a sample, the charged particle tool comprising the flood column of any proceeding claim.

15. A method for charged particle flooding of a sample using a flood column, the method comprising:
emitting a charged particle beam along a beam path using a charged particle source;
variably setting a beam angle of the emitted charged particle beam using a source lens arranged down-beam of the charged particle source;
adjusting the beam angle of the charged particle beam using a condenser lens arranged down-beam of the source lens; and
passing a portion of the charged particle beam using an aperture body arranged down-beam of the condenser lens.
